# EUROPÄISCHE PATENTANMELDUNG

(11) **EP 1 014 431 A2**
(43) Veröffentlichungstag der Anmeldung: **28.06.2000**
(21) Anmeldenummer: 99124785.9
(22) Anmeldetag: 14.12.1999
(51) Int. Cl.: H01L 21/203, C30B 23/02

(54) **Verfahren zur Herstellung epitaktischer Silizium-Germaniumschichten**

(30) Priorität: 22.12.1998 DE 19859429
(71) Anmelder: DaimlerChrysler AG, 70567 Stuttgart (DE)
(72) Erfinder: Kibbel, Horst, 89155 Erbach (DE); Kuchenbecker, Jessica, 89075 Ulm (DE)

(57) **Zusammenfassung**

Die Erfindung beschreibt ein Verfahren zur Herstellung von relaxierten Epitaxieschichten auf einem Halbleitersubstrat mittels Molekularstrahlepitaxie mit einer Wasserstoffquelle, indem in einer in situ Prozeßfolge
- an oder nahe der Substratoberfläche eine wasserstoffhaltige Zwischenschicht deponiert oder eingebracht wird,
- darauf eine verspannte Epitaxieschicht aufgewachsen wird und
- die Epitaxieschicht mittels einer Temperaturbehandlung relaxiert wird.

## Beschreibung

Die Erfindung bezieht sich auf ein Verfahren zur Herstellung von gitterangepaßten Silizium-Germaniumschichten nach dem Oberbegriff des Patentanspruchs 1 und auf eine Schichtenfolge nach Patentanspruch 14.

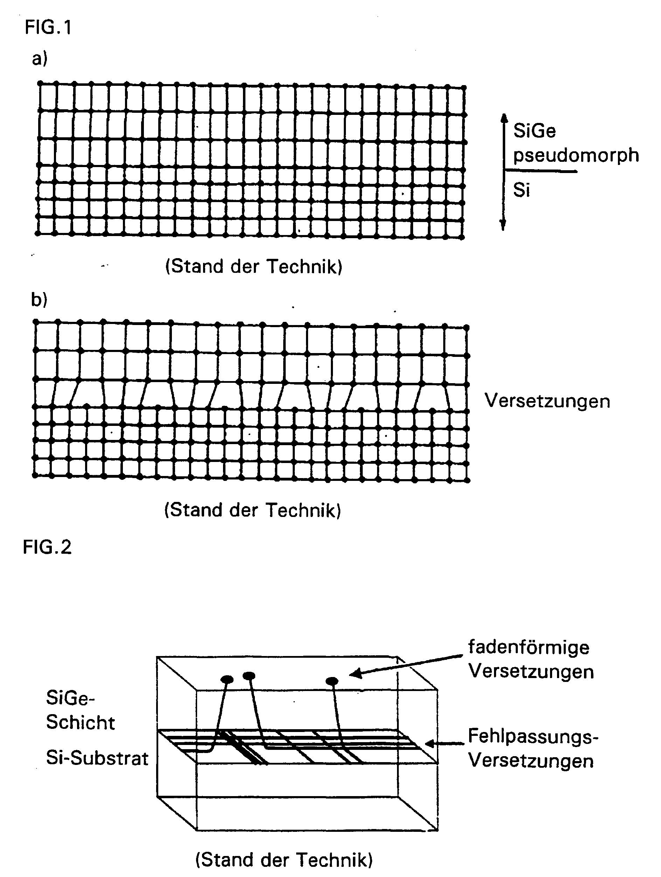

Viele Hochfrequenzbauelemente auf der Basis des Materialsystems SiGe/Si erfordern ein Substrat, dessen Gitterkonstante zwischen der des reinen Siliziums und der des reinen Germaniums angepaßt werden kann. Die Gitterfehlpassung in diesem Materialsystem beträgt, bezogen auf Si, für reines Germanium 4,2%. Wird eine Mischkristallschicht der Zusammensetzung Si₁₋ₓGeₓ - wobei x den Anteil von Germanium angibt - auf einem Siliziumsubstrat epitaktisch einkristallin abgeschieden, kommt es zunächst zur elastischen Verspannung in der wachsenden Si₁₋ₓGeₓ-Schicht (Fig. 1a), welche nach Überschreiten der sog. kritischen Schichtdicke durch Bildung von Fehlpassungsversetzungen bevorzugt in der Nähe der Grenzfläche abgebaut wird (Fig. 1b). Die kritische Schichtdicke ist abhängig von der Germaniumkonzentration x und der Wachstumstemperatur. Die parallel zur Grenzschicht verlaufenden Fehlpassungsversetzungen werden begleitet von einer hohen Anzahl von Versetzungen, die die Si₁₋ₓGeₓ-Pufferschicht von der Grenzfläche SiGe/Si bis zur Oberfläche der epitaktischen Schicht durchsetzen (Fig. 2). Die in der Figur bis an die Oberfläche reichenden fadenförmigen Versetzungen - im wissenschaftlichen Sprachgebrauch werden diese Versetzungen als 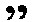 Threading"-Versetzungen bezeichnet - beeinträchtigen die Funktion der aktiven Bauelementschichten und sind daher möglichst zu unterdrücken.
Derart qualitativ hochwertige einkristalline, gitterangepaßte SiGe-Schichten werden auf gebräuchlichem Siliziumsubstrat als künstliche Substrate mittels Molekularstrahlepitaxie oder mittels Abscheidung aus einer reaktiven Gasphase (CVD-Verfahren) je nach Schichtdicke auf folgende Weise realisiert:
a) Für dicke Puffer im Bereich einer Schichtdicke von mehr als 1 µm wird der Germaniumgehalt während des Wachstums kontinuierlich oder in Stufen erhöht; wobei eine Zunahme des Germaniumgehaltes von beispielsweise 10% pro µm SiGe-Schichtdicke zugrunde gelegt wird. In der Regel wird die Wachstumstemperatur zur Unterdrückung dreidimensionalen Wachstums mit steigendem Germaniumgehalt reduziert.
   Bei dieser Lösung erfolgt die Gitteranpassung zwischen dem Siliziumsubstrat und der wachsenden SiGe-Schicht durch spannungsgetriebene Anpassungsversetzungen in der wachsenden SiGe-Schicht während des Wachstums (F. Schäffler, Semicond. Sci. Technol., 12, 1515 (1997) und T. Hackbarth, H. Kibbel, M Glueck, G. Hoeck, H. -J. Herzog, Thin Solid Films, 321 (1998), 136-140).
   Der Nachteil bei dieser Methode besteht darin, daß erst bei besonders großen Schichtdicken der benötigte Germaniumgehalt als Endkonzentration der als Pufferschicht wirkende SiGe-Schicht für elektronische Bauelemente erzielbar ist. Aufgrund der Schichtdicke ergeben sich auf einem gemeinsamen Wafer beispielsweise mit Siliziumbauelementen Höhendifferenzen, die mit der modernen Integrationstechnik unvereinbar sind oder zumindest Schwierigkeiten bei der Hochintegration bereiten.
   Ferner ist die Oberflächentopographie dieser dicken, bei hohen Temperaturen gewachsenen SiGe-Pufferschichten für nachfolgende Strukturen mit dünnen Einzelschichten bereits nachteilig, da die Verwerfungen der Oberflächenstruktur in vertikal vergleichbarer Dimension der aktiven Bauelementschichten sein können.
b) Für dünne Pufferschichten im Bereich einer Schichtdicke von weniger als 1 µm wird eine verspannte, nicht gitterangepaßte SiGe-Pufferschicht mit konstantem oder auch gradiertem Germaniumgehalt epitaktisch abgeschieden, welche nachträglich mit Wasserstoffatomen implantiert und durch einen anschließenden Temperprozeß unter Schutzgas relaxiert wird. Dosis und Energie des Wasserstoffs werden so gewählt, daß das Maximum der Wasserstoffkonzentration noch innerhalb des Siliziumsubstrats, jedoch relativ nahe der Grenzschicht zur SiGe-Pufferschicht liegt. Der anschließende Temperprozeß, der bei Temperaturen im Bereich von 800°C erfolgt, führt dann zu einer Gitteranpassung infolge der Ausbildung von Anpassungsversetzungen, die überwiegend in der dünnen Siliziumschicht zwischen der Grenzschicht und dem Maximum der Wasserstoffkonzentration verlaufen (S. Mantl, B. Holländer, R. Liedke, 5. Mesters, H.- J. Herzog, H. Kibbel, T. Hackbarth, Thin Solid Films, im Druck befindlich, publiziert auf EMRS, Straßburg 1998).

Diese Lösung besitzt Nachteile, indem eine üblicherweise außerhalb der Epitaxieanlage - ex situ - erfolgende Implantation mit relativ hohen Energien in Verbindung mit einem nachfolgenden Temperprozeß zur Relaxation erforderlich ist. Erst danach kann auf der relaxierten SiGe-Schicht die eigentliche Bauelementstruktur gewachsen werden. Der Transfer des Wafers nach der 1. Stufe der Epitaxie außerhalb der Anlage, um die Implantation und Temperung durchzuführen, erschwert die Fortführung der nachfolgenden Epitaxie durch eine erneut erforderliche Vorpräparation des Wafers. Die Implantation von Wasserstoff birgt ferner die Gefahr von Kristallschäden an der Oberfläche bzw. im Volumen, die nicht vor der Relaxation des SiGe-Puffers durch eine thermische Behandlung ausgeheilt werden können, weil dadurch auch der implantierte Wasserstoff durch Diffusion ins Volumen verdünnt wird und seine relaxationsunterstützende Eigenschaft verliert.
Sollte zudem die erforderliche Germanium-Endkonzentration nicht in einer Abfolge der Schritte Epitaxie, H-Implantation und Temperung erreicht werden können, müßte die vorgenannte Prozedur mehrstufig durchgeführt werden. Dies ginge dann durch die erforderliche mehrfache Vorpräparation auf Kosten der Kristallqualität.

Ferner ist ein wesentlich höheres Temperaturbudget zur Relaxation erforderlich, das in Kombination mit dem vorhandenen Wasserstoff zu einer höheren Diffusion in bereits vorhandenen Bauelementstrukturen führen kann. Außerdem verursacht die erforderliche Implantationsanlage zusätzliche und durch die Komplexität derartiger Anlagen bedingte hohe Kosten.

Neben der Molekularstrahlepitaxie ist auch eine Abscheidung epitaktischer Schichten aus einer chemisch reaktiven Gasphase (CVD-Verfahren) gebräuchlich und aufgrund wirtschaftlicher Vorteile weit verbreitet. Allerdings stellt die Schichtabscheidung mittels CVD im Regelfall nicht die Variabilität der Prozeßführung zur Verfügung, die in Grenzbereichen kinetisch gesteuerter Oberflächenreaktionen erforderlich wäre, um eine besonders gute Schichtqualität zu erzielen. Meist muß bei dieser Methode unerwünscht in einem erheblich höheren Temperaturbereich gearbeitet werden.

So ist beispielsweise aus den Schriften EP 0 746 011 A2 und EP 0 493 278 A1 eine Oberflächenreinigung eines Halbleitermaterials unter Verwendung von wasserstoffhaltigem Plasma bekannt, mit der eine auf einem Siliziumsubstrat befindliche natürliche Oxidschicht vor einem Depositionsprozeß abgetragen wird. Die derart gereinigte Siliziumoberfläche wird dann aus einer im wesentlichen monoatomaren Wasserstoffbelegung bedeckt. Üblicherweise liegen sowohl beim Reinigungsprozeß wie auch bei der nachfolgenden Schichtabscheidung die Temperaturen bei ca. 800°C, gelegentlich sogar im Bereich von 1000°C und darüber. Derart hohe Temperaturen und die kinetische Reaktion der Gasphase mit der Substratoberfläche führt immer dazu, daß im Stadium der Schichtabscheidung eine mehr oder weniger geschlossene Wasserstoffoberfläche durch eine chemische Reaktion mit der schichtbildenden Spezies ersetzt wird und die dann mit der sich neu bildenden Schichtoberfläche im Wachstum fortschreitet.
Bei derartigen Wachstumsbedingungen erscheint jedoch ein gezieltes Einbringen von Wasserstoff in einen eng begrenzten Bereich einer Schichtfläche prozeßtechnisch geradezu unmöglich.

Der Erfindung liegt die Aufgabe zugrunde, ein Verfahren zur Herstellung und eine Schichtenfolge anzugeben, mit der dünne, gitterangepaßte Halbleiterschichten mit geringer Versetzungsdichte an der Oberfläche hergestellt werden können.

Die Erfindung wird in Bezug auf das Verfahren durch die Merkmale des Patentanspruchs 1 und in Bezug auf die Schichtenfolge durch die Merkmale des Patentanspruchs 14 wiedergegeben. Die weiteren Ansprüche enthalten vorteilhafte Aus- und Weiterbildungen der Erfindung.

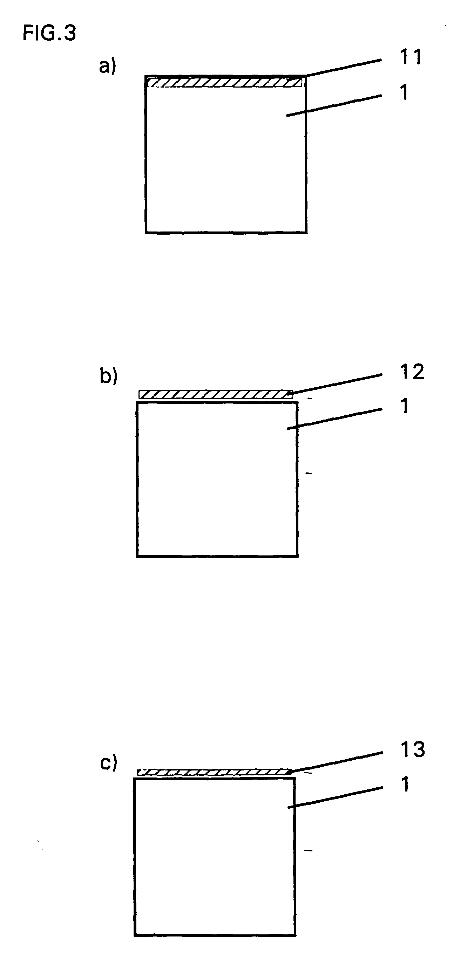

Die Erfindung beinhaltet ein Verfahren zur Herstellung von relaxierten Epitaxieschichten auf einem Halbleitersubstrat mittels eines Epitaxieverfahrens, insbesondere der Molekularstrahlepitaxie, in Verbindung mit einer Wasserstoffquelle in einer in situ Prozeßfolge. Hierzu wird auf dem Substrat eine wasserstoffhaltige Zwischenschicht deponiert oder in ein Substrat eine Diffusionsschicht eingebracht, die an oder nahe der Oberfläche liegt. Auf die Zwischenschicht wird eine verspannte Epitaxieschicht aufgewachsen, die anschließend mittels einer Temperaturbehandlung bei vergleichsweise niedriger Temperatur relaxiert wird.
Die Herstellung der Zwischenschicht kann auf drei unterschiedliche Weisen erfolgen (Fig. 3 a-c).
1) Die Diffusionsschicht wird durch thermische und/oder plasmaunterstützte Eindiffusion von Wasserstoff in die Substratoberfläche eingebracht, wobei die Konzentration des eindiffundierten Wasserstoffs an der Substratoberfläche eine maximale Konzentration der Größenordnung 10¹⁹ bis 10²¹ cm⁻³ erreicht.
2) Die Zwischenschicht wird durch reaktive Epitaxie bei einer Temperatur von max. 500°C unter Wasserstoffbeimischung mit hoher Konzentration in einer Dicke zwischen einigen Atomlagen bis 10 nm abgeschieden. Dabei erreicht die Konzentration des Wasserstoffs in der Schicht die Größenordnung von 10¹³ bis 10¹⁴ cm⁻² (bzw. 10¹⁹ bis 10²¹ cm⁻³).
3) Die Zwischenschicht wird aus einer monoatomaren Belegung der Substratoberfläche mit einer Konzentration der Größenordnung 10¹⁴ bis 10¹⁵ cm⁻² unter Bildung von Si-H-Bindungen hergestellt.
   Bei allen drei Varianten findet die Temperaturbehandlung im Bereich von 450 bis 650 °C statt.
   Als Wasserstoffquelle werden in einer Molekularstrahlepitaxieanlage vorzugsweise Niederenergieplasma oder H/H₂ Molekularstrahlquellen verwendet.

Das Halbleitersubstrat besteht entweder aus Silizium oder aus einer beliebigen SiGe-Legierung. Die Legierung kann auch auf einem ursprünglichen Siliziumsubstrat aufgewachsen werden und im weiteren Verlauf der Prozeßfolge die Funktion eines neuen Substrates für die darauffolgenden Schichten übernehmen. Auf diese Weise können bei der in situ Prozeßfolge auch mehrere relaxierte Epitaxieschichten - sogar bis zu einem Germaniumgehalt von x = 1 - aufeinanderfolgend abgeschieden werden. Als oberste Epitaxieschicht folgt dann eine weitere Pufferschicht oder eine zur Bauteilherstellung benötigte Schicht.

Ein besonderer Vorteil der Erfindung besteht darin, daß der erfindungsgemäße Herstellungsprozeß die Möglichkeit bietet, die komplette vertikale Schichtstruktur ohne Unterbrechung des Vakuums in situ zu realisieren, die eine weitgehende Unterdrückung von an die Oberfläche laufenden Threading-Versetzungen gewährleisten; sogar eine mehrstufige Abfolge relaxierter Schichten ist problemlos ohne Transport an Atmosphäre möglich.

Ein weiterer besonderer Vorteil besteht im geringen thermischen Budget der Temperung. Gegebenenfalls können dadurch sogar eine partielle Positionierung der gitterangepaßten SiGe-Pufferschichten bei der Prozessierung von bereits auf einem Substrat vorhandenen Bauelementstrukturen in Silizium-Technologie durchgeführt werden. Derart verträglichen Prozeßbedingungen bleiben, vor allem durch das niedrige Temperaturbudget bedingt, ohne negative Folgen für die bereits auf einem Substrat vorhandenen Strukturen.

Im folgenden wird die Erfindung anhand von vorteilhaften Ausführungsbeispielen unter Bezugnahme auf schematische Zeichnungen in den Figuren näher erläutert. Es zeigen:
- Fig. 1 a: Atomgitter einer epitaktisch abgeschieden Si₁₋ₓGeₓ-Schicht auf einkristallinem Silizium - elastische Verspannung - (Stand der Technik),
- Fig. 1 b: Atomgitter einer epitaktisch abgeschieden Si₁₋ₓGeₓ-Schicht auf einkristallinem Silizium unter Bildung von Fehlpassungsversetzungen in der Nähe der Grenzfläche - Spannungsrelaxation - (Stand der Technik),
- Fig. 2: Schematische Darstellung der Ausbildung und Verlauf von fadenförmigen Threading-Versetzungen und Fehlpassungsversetzungen im Kristallvolumen (Stand der Technik),
- Fig. 3: a) Oberflächennahe Wasserstoffdeposition im Substrat
b) Wasserstoffdeposition durch reaktive, epitaktische Schichtabscheidung auf dem Substrat
c) Oberflächliche Wasserstoffdeposition auf der Substratoberfläche,
- Fig. 4: Schichtenfolge mehrerer aufeinanderfolgend abgeschiedener relaxierter Epitaxieschichten mit weiterer Deckschicht,
- Fig. 5: Konzentrationsverlauf von eindiffundiertem Wasserstoff mit Maximalwert an der Substratoberfläche,
- Fig. 6: Rocking-Kurve von Schichtenfolgen, die bei unterschiedlichen Temperaturen prozessiert wurden; Messung des Spannungsabbaus durch Gitterkonstantenänderung der Epitaxieschicht.

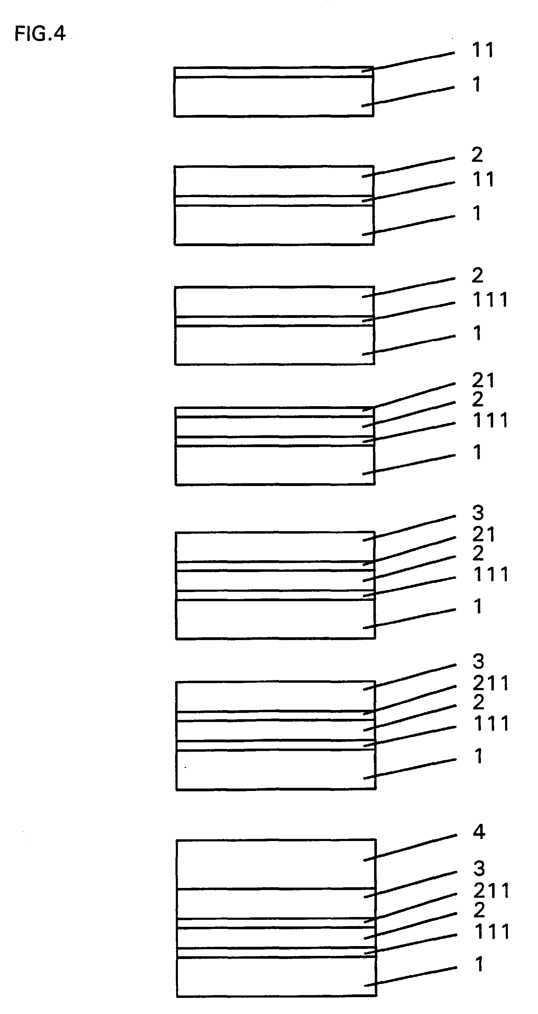

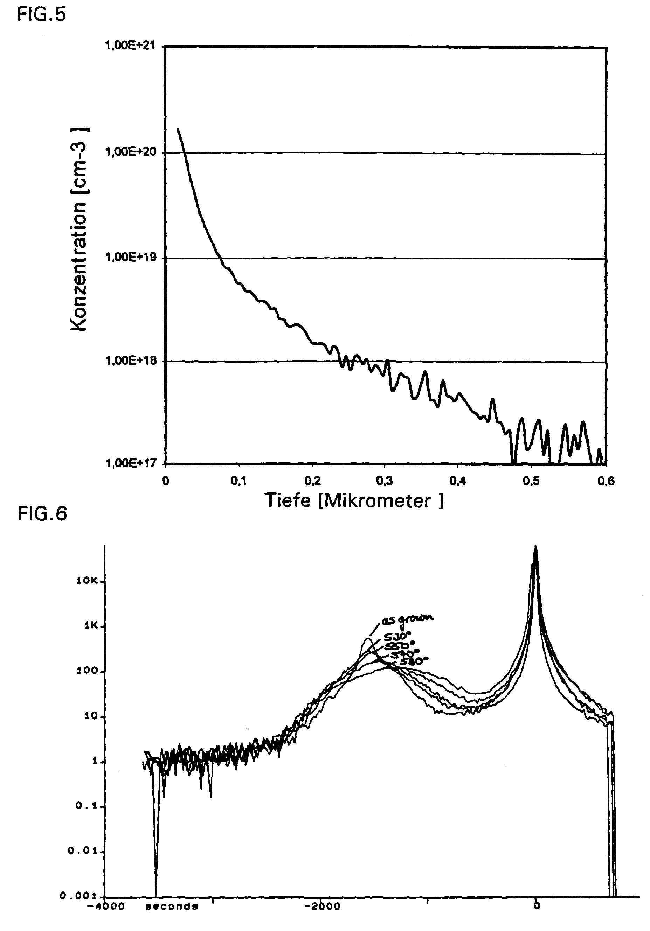

In einem ersten Ausführungsbeispiel wird nach Fig. 4 erfindungsgemäß die weitgehende Unterdrückung der an die Schichtoberfläche laufenden Threading-Versetzungen bei dünnen Puffern mit einer Schichtdicke unter 1 µm durch eine 2-stufigen Vorbehandlung, Wachstum und Zwischenbehandlung der von Siliziumsubstrat und als Epitaxieschicht ausgebildete SiGe-Pufferschicht erreicht. Dabei wird in einem ersten Prozeßschritt die später zu bewachsende Fläche des Substrats 1 einer Wasserstoffquelle dergestalt ausgesetzt, daß der Wasserstoff oberflächennah in das Kristallvolumen eindiffundiert wird. Das zugehörige erste Diffusionsprofil 11 ist in Fig. 5 im Konzentrationsverlauf beispielhaft für eine plasmaunterstützte Eindiffusion dargestellt, bei dem der Maximalwert an der Substratoberfläche liegt. Oberflächennah können Wasserstoftkonzentrationen im Bereich von 10²⁰ cm⁻³ erreicht werden.

In einem folgenden Prozeßschritt wird eine erste Si₁₋ₓGeₓ-Pufferschicht 2 mit z.B. x = 0,2 und 150nm Dicke aufgewachsen. Dies erfolgt bei einer Wachstumstemperatur von beispielsweise 550°C mit Wachstumsraten von ca. 0,3nm/s.
Danach wird in situ das Siliziumsubstrat 1 mit der ersten Si₁₋ₓGeₓ-Pufferschicht 2 auf 590°C erhitzt, wodurch die Si₁₋ₓGeₓ-Pufferschicht 2 durch Bildung von vorwiegend Misfit-Versetzungen relaxiert. Die Ausbildung der Versetzungen verläuft entlang einer ersten wasserstoffhaltigen Grenzfläche 111 von Substrat und Epitaxieschicht. Einen Überblick des Relaxationsprozesses in Abhängigkeit von der Temperatur im Bereich von 530 bis 590°C ist aus Fig. 6 in Form einer Rocking-Kurve zu entnehmen. Bei den in der Figur dargestellten Meßkurven wird der Spannungsabbau durch Gitterkonstantenänderung der Epitaxieschicht erfaßt. Damit ist die erste Si₁₋ₓGeₓ-Pufferschicht 2 nun thermisch stabil, der deponierte Wasserstoff ist nach der Temperung durch Diffusion an die Oberfläche und das Volumen durch Verdünnung wirkungslos.
Bei einem weiterer Prozeßschritt wird der bisherige Schichtstapel erneut der Wasserstoffdiffusion ausgesetzt, um wiederum ein in Fig. 4 dargestelltes zweites Diffusionsprofil 21 zu erzeugen.
Danach wird eine zweite Si₁₋ₓGeₓ-Pufferschicht 3 mit z.B. x = 0,4 und 150nm Dicke aufgewachsen. Die relative Erhöhung der Germaniumkonzentration bezüglich der ersten Pufferschicht 2 beträgt wiederum 0,2. Dieses erfolgt wieder bei einer Wachstumstemperatur von beispielsweise 550°C mit Wachstumsraten von ca. 0,3nm/s.
Beim darauffolgenden Prozeßschritt wird der Schichtstapel erneut bei 590°C in situ unter Bildung einer erneuten thermisch stabilen zweiten Pufferschicht 3 getempert. Wiederum ist der deponierte Wasserstoff unter Ausbildung der zweiten wasserstoffhaltigen Grenzfläche 211 nach der Temperung durch Diffusion an die Oberfläche und das Volumen durch Verdünnung wirkungslos. Damit sind die Voraussetzungen für eine nachfolgende Abscheidung einer vertikalen Bauelementstruktur 4 geschaffen, die unmittelbar danach abgeschieden wird.
Der Wasserstoffdiffusionsprozeß findet bei allen Prozeßschritten vorzugsweise in der Wachstumskammer selbst oder in einer unmittelbar mit dieser verbundenen Präparationskammer statt.

## Patentansprüche

1. Verfahren zur Herstellung von relaxierten Epitaxieschichten auf einem Halbleitersubstrat mittels eines Epitaxieverfahrens, insbesondere der Molekularstrahlepitaxie, mit einer Wasserstoffquelle, dadurch gekennzeichnet, daß in einer in situ Prozeßfolge
- an oder nahe der Substratoberfläche eine wasserstoffhaltige Zwischenschicht (11, 12, 13) deponiert oder eingebracht wird,
- darauf eine verspannte Epitaxieschicht aufgewachsen wird und
- die Epitaxieschicht mittels einer Temperaturbehandlung relaxiert wird.

2. Verfahren nach Anspruch 1, dadurch gekennzeichnet, daß eine Diffusionsschicht (11) durch thermische und/oder plasmaunterstützte Eindiffusion von Wasserstoff in die Substratoberfläche (1) eingebracht wird.

3. Verfahren nach Anspruch 2, dadurch gekennzeichnet, daß die Konzentration des eindiffundierten Wasserstoffs an der Substratoberfläche eine maximale Konzentration der Größenordnung 10¹⁹ bis 10²¹ cm⁻³ erreicht.

4. Verfahren nach Anspruch 1, dadurch gekennzeichnet, daß durch reaktive Epitaxie unter Wasserstoffbeimischung eine dünne Zwischenschicht (12) mit hoher Wasserstoffkonzentration deponiert wird.

5. Verfahren nach Anspruch 4, dadurch gekennzeichnet, daß die Zwischenschicht (12) mit einer Dicke zwischen einigen Atomlagen bis 10 nm abgeschieden wird.

6. Verfahren nach Anspruch 4, dadurch gekennzeichnet, daß die Konzentration des Wasserstoffs in der Schicht die Größenordnung 10¹³ bis 10¹⁴ cm⁻² (bzw. 10¹⁹ bis 10²¹ cm⁻³) erreicht.

7. Verfahren nach Anspruch 1, dadurch gekennzeichnet, daß die Zwischenschicht (13) aus einer monoatomaren Belegung der Substratoberfläche hergestellt wird.

8. Verfahren nach Anspruch 7, dadurch gekennzeichnet, daß die monoatomare Belegung eine Konzentration der Größenordnung 10¹⁴ bis 10¹⁵ cm⁻² erreicht.

9. Verfahren nach Anspruch 1, dadurch gekennzeichnet, daß die Temperaturbehandlung im Bereich von 450 bis 650 °C stattfindet.

10. Verfahren nach Anspruch 1, dadurch gekennzeichnet, daß bei der Abscheidung der wasserstoffhaltigen Zwischenschicht als Wasserstoffquelle vorzugsweise Niederenergieplasma oder H/H₂ Molekularstrahlquellen verwendet werden.

11. Verfahren nach einem der vorhergehenden Ansprüche, dadurch gekennzeichnet, daß das Halbleitersubstrat (1) aus Silizium oder aus einer beliebigen SiGe-Legierung besteht.

12. Verfahren nach einem der vorhergehenden Ansprüche, dadurch gekennzeichnet, daß bei der in situ Prozeßfolge mehrere relaxierte Epitaxieschichten aufeinanderfolgend abgeschieden werden.

13. Verfahren nach einem der vorhergehenden Ansprüche, dadurch gekennzeichnet, daß auf die oberste Epitaxieschicht eine Bauelementstruktur (4) epitaktisch aufgewachsen wird.

14. Schichtenfolge, hergestellt nach einem der Ansprüche 1 bis 13, bestehend aus:
- einem Substrat (1) aus Silizium mit auf oder eingebrachter wasserstoff haltigen Zwischenschicht (111) und aufeinanderfolgend,
- einer relaxierten Si₁₋ₓGeₓ- Epitaxieschicht der Konzentration x = 0,1 bis 0,3 als erste Pufferschicht mit auf oder eingebrachter wasserstoffhaltiger Zwischenschicht (211),
- eine SiₓGe₁₋ₓ- relaxierte Epitaxieschicht der Konzentration x = 0,3 bis 0,5 als zweite Pufferschicht (3) und
- einer SiₓGe₁₋ₓ Bauelementstruktur (4).

15. Schichtenfolge nach Anspruch 14, dadurch gekennzeichnet, daß nach der zweiten Pufferschicht (3) weitere relaxierte SiₓGe₁₋ₓ- Epitaxieschicht mit ansteigender Germaniumkonzentration bis zu maximal x = 1 abgeschieden sind und zuletzt die Bauelementstruktur (4) folgt.
